# EUROPEAN PATENT APPLICATION

(11) **EP 4 001 767 A1**
(43) Date of publication of application: **25.05.2022**
(21) Application number: 20208545.2
(22) Date of filing: 19.11.2020
(51) Int. Cl.: F24C 7/08, H03K 17/96

(54) **USER INTERACTION DEVICE, HOUSEHOLD APPLIANCE AND METHOD FOR MANUFACTURING A USER INTERACTION DEVICE**

(71) Applicant: ELECTROLUX APPLIANCES AKTIEBOLAG, 105 45 Stockholm (SE)
(72) Inventor: WUNDLING, Holger, 91541 Rothenburg ob der Tauber (DE); HOLZINGER, Jochen, 91541 Rothenburg ob der Tauber (DE); BAYERLEIN, Stefan, 91541 Rothenburg ob der Tauber (DE)
(74) Representative: Electrolux Group Patents

(57) **Abstract**

A user interaction device for entering information and/or control commands to an input means (21) of a household appliance (10) has at least one touch sensitive control element. The touch sensitive control element comprises an electrically conductive signal transmitting element (42). A first end (50) or end portion of the electrically conductive signal transmitting element (42) contacts a contact point on a circuit board (36') and a second end or end portion (42c) forms or contacts a touch sensitive area on or allocated to a touch surface of the input means (21). The at least one electrically conductive signal transmitting element (42) is supported and/or held in place by a retainer element (44). The retainer element (44) is arranged in a stationary position towards the circuit board (36'), in particular towards the contact point on the circuit board (36').

Further, a method for manufacturing a user interaction device for a household appliance (10) is disclosed.

## Description

The present invention relates to a user interaction device for entering information and/or control commands to an input means comprising at least one touch sensitive control element, according to claim 1. Further, the present invention relates to a household appliance, according to claim 10. Finally, the present invention relates to a method for manufacturing a user interaction device for a household appliance, according to claim 11.

Household appliances and other electrically controlled apparatuses and appliances are equipped with control units operable by a user via switch elements. Nowadays, touch control elements are commonly used in such appliances, rather than mechanical switching elements. Said touch control elements are operated by simply touching these elements. The actual switching function is performed then by electronic switching elements or relays that are usually included in an electronic circuitry arranged on a circuit board. All said elements are elements of a user interface, which is included in or connected with a user interaction device. In the case of a cooking hob, which may be covered by a glass ceramic plate, such touch control elements are even more preferred since there is no need for breakthroughs in this plate and the cleaning of a continuous surface is particularly user-friendly. However, in case of a use of a plurality of such touch control elements quite a number of process steps, in particular soldering of conductive signal transmitting elements, have to be performed during the assembly of said user interaction device and some of these process steps require manual handling.

It is an object of the present invention to provide a user interaction device and a household appliance with such a user interaction device, which contribute to a simplified assembling process and which are constructed in such a way that the level of automation in production facilities of household appliances can be further increased. It is a further object of the present invention to provide a method for manufacturing a user interaction device for a household appliance, which simplifies the manufacturing process of a household appliance.

According to one aspect of the invention, the object is achieved by a user interaction device for entering information and/or control commands to an input means with at least one touch sensitive control element, which comprises an electrically conductive signal transmitting element. A first end or end portion of the electrically conductive signal transmitting element contacts a contact point on a circuit board and a second end or end portion forms or contacts a touch sensitive area on or allocated to a touch surface of the input means. The at least one electrically conductive signal transmitting element is supported and/or held in place by a retainer element, which is arranged in a stationary position towards the circuit board, in particular towards the contact point on the circuit board.

The household appliance is particularly a cooking appliance and may be a cooking hob, in particular an electrically driven cooking hob. A specifically selected appliance is an induction cooking hob.

Said input means may be a user interface of a household appliance. In case of a cooking hob, the user interface may be in a horizontal alignment and it may be arranged at a front side or front edge of a cooking surface, which may be provided on a glass plate, preferably on a glass ceramic plate.

The electrically conductive signal transmitting element of the touch sensitive control element may be of any kind of electrically conductive material, which enables transmission of an electric signal from a contact area on a touch surface of the input means. Said electrically conductive material is preferably elastically deformable in order to support an adequate contacting to the related surface or surfaces. A specifically preferred embodiment is a metallic spring, for example a spiral spring or a Z-shaped or an S-shaped spring.

Preferably, the contact point on the circuit board is a solder pad or any kind of a, particularly broadened, conductor path of the circuit board and the first end or end portion of the electrically conductive signal transmitting element, for example of the metallic spring, is pressed against the solder pad or the conductor path. Said pressing is favourably provided or supported by elastic force, notably by spring force. With such pressing, a more secure contact can be provided, since the respective pressure force reduces the contact resistance usually occurring at contact points. Moreover, the contact resistance may be further reduced by a provision of contact surfaces of higher quality, obtained particularly by means of gold coating.

In order to provide an even more secure solution for the contact between the first end or end portion of the electrically conductive signal transmitting element and the solder pad or conductor path, additionally or alternatively to the described provision of pressure between these two elements, the first end or end portion of the electrically conductive signal transmitting element may be fixed to the solder pad or the section of the conductor path by means of soldering or welding. Particularly the soldering process may be performed in that the first end or end portion is positioned on the related solder pad or the section of the conductor path and kept in this position, while the complete arrangement passes through a solder bath, thereby establishing the solder joint between said elements.

According to an embodiment, the second end or end portion of the electrically conductive signal transmitting element is a metal strip or a metal plate, which abuts on a bottom side or a reverse side of an operating panel of the input means. Preferably, the entire surface of the metal strip or plate is in contact with said bottom or reverse side. The metal strip or metal plate is pressed against the bottom or reverse side of the operating panel. This pressure may be exerted by means of elastic force, which is specifically a spring force. In particular, the metal plate is of a rectangular or square shape, wherein one edge of such rectangle or square may be a borderline to a spiral or Z-shaped middle section of the spring element.

One preferred embodiment is characterized by a retainer element, which is arranged between and optionally spaced away from the circuit board and the touch surface or an operating panel, e. g. the glass panel, of the input means. The retainer element may be arranged in an orientation at least approximately in parallel with at least one of the circuit board and the input means and/or the operating panel. A specifically preferred embodiment provides a parallel alignment of all these components, i. e. of the circuit board, the input means and/or operating panel and the retainer element. That way, in principle a sandwich-like structure is provided. An at least approximately halfway or centred fixation of the electrically conductive signal transmitting element is advantageous with regard to a preferably precise positioning of its ends or end portions in relation to the contact point on the circuit board and to the location of the touch sensitive area on or allocated to the touch surface of the input means.

The retainer element may comprise or may be connected to a first means of a clipping or snapping mechanism, which interacts with a second means of the clipping or snapping mechanism. The second means may be arranged or arrangeable at the user interaction device, in particular at a housing of the user interaction device, or at the circuit board. First and second means of the clipping or snapping mechanism may be designed in a way as to provide a fixation of the retainer element in a predetermined distance from the circuit board.

Preferably, at least two electrically conductive signal transmitting elements are supported and/or held in place by the retainer element. The electrically conductive signal transmitting elements are arranged at or combined with the retainer element such that they are connectable to their related contact points on the circuit board by a single assembly step, which may be exerted on the retainer element. It is preferred to provide the electrically conductive signal transmitting elements to be simultaneously connectable.

According to an embodiment, the at least two electrically conductive signal transmitting elements are at least two spiral springs or Z-shaped or S-shaped springs. Said spiral springs or Z- or S-shaped springs may by of identical shape and/or of identical spring force. The retainer element surrounds or embeds portions or sections, preferably middle portions or middle sections, of the at least two spiral or Z- or S-shaped springs. The portions or sections are particularly in the same spring sections of the two springs. More particularly, said portions or sections are spaced from the first and/or second ends or end sections of the related spring with the same distance.

The retainer element may be made of a plastic material and the at least two electrically conductive signal transmitting elements are specifically enclosed by the retainer element during an injection moulding process. This is favourable not only with respect to an effective electrical insulation between the two electrically conductive signal transmitting elements but also with respect to a simple inclusion process of the electrically conductive signal transmitting elements in the retainer element.

One embodiment provides that the at least one electrically conductive signal transmitting element and/or the retainer element is or are included in or coupled with a light guide element for a guided light signal transmission from a light source on the circuit board to the input means. In particular, the guided light signal is transmitted to a display field on the user interface of the household appliance. The display field is particularly arranged on the operating panel. The combination of a light guide element with the retainer element supporting the at least one electrically conductive signal transmitting element or directly with the at least one electrically conductive signal transmitting element is particularly favourable with respect to a simplified manufacturing process of the household appliance. Moreover, the assembly of the component, which includes or couples the light guide element with the retainer element or the at least one electrically conductive signal transmitting element, may be performable by an automated assembling process, preferably executed by an assembly robot.

According to another aspect of the invention, the object is also achieved by a household appliance, particularly a kitchen appliance, more particularly a cooking hob, specifically an induction cooking hob, which comprises anyone of the described embodiments of the user interaction device.

According to yet another aspect of the invention, the object is also achieved by a method for manufacturing a user interaction device for a household appliance, which method comprises the steps
a. assembly of an electronic circuit on a circuit board;
b. integration of at least one electrically conductive signal transmitting element in a retainer element for a touch sensitive control element; and
c. arrangement of the retainer element on or above the circuit board.

The method is particularly designed for being applied on a user interaction device according to anyone of the described embodiments of the user interaction device. The at least one electrically conductive signal transmitting element may be at least one metallic spring. A particularly preferred embodiment is characterized by a plurality of electrically conductive signal transmitting elements, i. e. at least two of such elements, specifically at least two metallic springs, may be integrated in the retainer element, particularly during the same process step and/or with a predetermined local allocation to each other.

The household appliance, to which the method applies or which is designed for the method to be applied on, is particularly a cooking appliance and may be a cooking hob, in particular an electrically driven cooking hob. A specifically selected appliance is an induction cooking hob. Further, it may be a household appliance according to anyone of the afore-described embodiments.

In particular, each of the steps a. to c. is performed in an automated assembly process. Additionally or alternatively, the step c. may be performed at least approximately orthogonally to the circuit board. The execution of steps a. and b. may be independent from each other and/or in arbitrary chronological order, while the step c. is the final one of the steps a. to c.. Moreover, the steps a. and b., particularly all steps a. to c., may be performed in different premises. The step b. may comprise an injection moulding process step, in particular the at least one electrically conductive signal transmitting element may be embedded in the retainer element during such a process step.

According to one specific embodiment of the method, the at least one electrically conductive signal transmitting element is pressed against a contact point on the circuit board during step c.. According to a preferred embodiment, at least two electrically conductive signal transmitting elements are, in particular simultaneously, pressed against related contact points during step c.. At least one of the one or more contact points is particularly a solder pad or a section of a conductor path. The contact pressure is preferably exerted by creating a spring preload.

The retainer element may be arranged on the circuit board by establishing a snap coupling or clip connection.

Novel and inventive features of the present invention are set forth in the appended claims.

The present invention will be described in further detail with reference to the drawing, in which
- Fig. 1: illustrates the general structure of an induction cooking hob in an exploded perspective view;
- Fig. 2: is a perspective top view of an assembled induction cook-ing hob designed similar to Fig. 1 including component groups;
- Fig. 3: is an enlarged top view of a part of the user interface, indicated in Fig. 2 by detail III;
- Fig. 4: is a perspective top view of a second embodiment of the user interface according to Fig. 3, illustrated without its housing;
- Fig. 5: is an exploded view of the user interface according to Fig. 4;
- Fig. 6: is a top view of the user interface according to Fig. 4;
- Fig. 7: is a section view of detail VII - VII in Fig. 6; and
- Fig. 8: is a section view of detail VIII - VIII in Fig. 6.

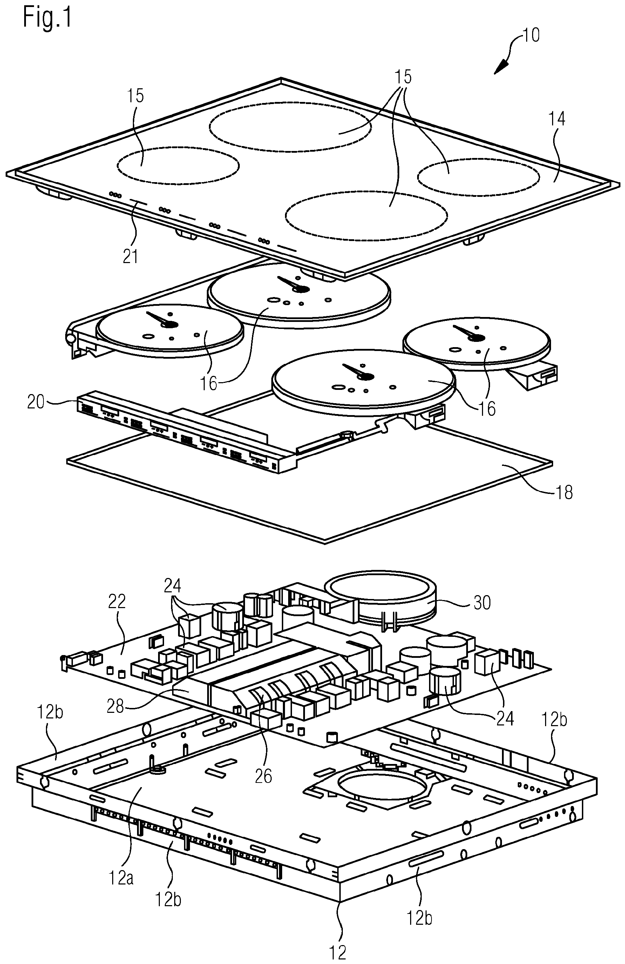

Fig. 1 illustrates an exploded perspective view of the general structure of a cooking hob 10.

The cooking hob 10 comprises a casing 12 and a panel 14. The casing 12 includes a bottom wall 12a, four sidewalls 12b and an open top side. Preferably, the casing 12 is made of metal, e.g. steel. Alternatively, the casing 12 may be made of plastics. The panel 14 covers the top side of the casing 12. For example, the panel 14 is a glass ceramic panel.

The cooking hob 10 comprises four circular cooking zones 15, two thereof with a smaller diameter, while the diameter of the other two cooking zones 15 are larger. The contours of the cooking zones are indicated by respective circles on the top surface of the glass panel 14. Each cooking zone 15 receives its heating power from a heating element 16 arranged beneath the panel 14.

A carrier 18 supports the heating element 16. Said carrier 18 is arranged beneath the heating elements 16. The carrier 18 is a metallic plate, preferably made of an aluminium material, and may be of an extension adapted to carry all four heating elements 16, in that having dimensions close to the dimensions of the glass panel 14. Alternatively, four carriers 18 may be provided, each carrier 18 supporting merely one dedicated heating element 16.

The cooking hob 10 further comprises a user interface 20 for enabling user inputs including also a control panel for controlling the cooking hob functions. The user interface 20 includes touch sensors and display means corresponding with a user interface zone 21 arranged at the front edge of the glass panel 14.

Preferably, the heating element 16 is an electric heating element. At least one printed circuit board 22 is arranged above the bottom wall 12a of the casing 12. A plurality of electric and/or electronic elements 24, 26 is attached on the printed circuit board 22. The printed circuit board 22 including the electric and/or electronic elements 24, 26 forms a power board of the cooking hob 10. Power electronic elements 26 for supplying the heating elements 16 with electrical power are attached to a cooling channel 28, which extends horizontally through the cooking hob 10. An air stream driven by at least one fan 30 passes the cooling channel 28 and cools down the power electronic elements 26.

In this example, the cooking hob 10 is an induction cooking hob, wherein the heating element 16 is a heating coil unit 16 comprising an induction coil and the carrier 18 is a coil carrier.

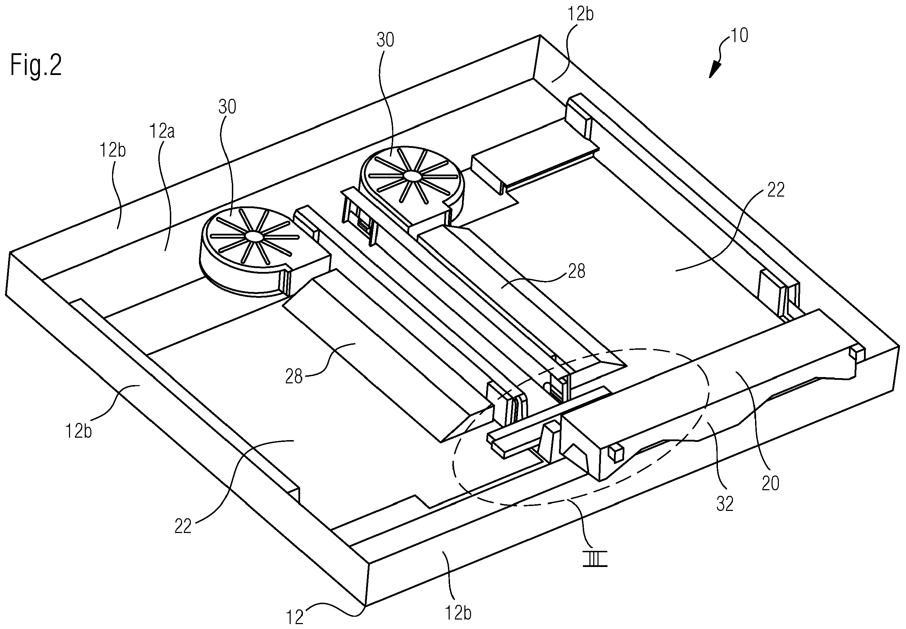

Fig. 2 illustrates schematically an assembled induction cooking hob 10 designed similar to Fig. 1. The assembly of Fig. 2 mainly differs from the solution of Fig. 1 in that the single power board 22 of Fig. 1, which is configured to supply all four cooking zones 15, is split into two power boards 22, each one thereof supplying two cooking zones 15 arranged one behind the other. Further, for the sake of clarity, Fig. 2 only shows the electrical components of the induction cooking hob 10 in the form of two power boards 22 and the user interface 20 arranged in the casing 12. Further components arranged above the power boards 22 and the user interface 20, e. g. heating coils units 16 and glass panel 14, are left out. Also the power boards 22 are illustrated only schematically, particularly without any electric and electronic parts, except their cooling channels 28 and associated fan 30. Moreover, the user interface 20 is also shown in Fig. 2 without any details, but it is indicated as being arranged in a user interface carrier 32 that is supported against the bottom wall 12a of the casing 12.

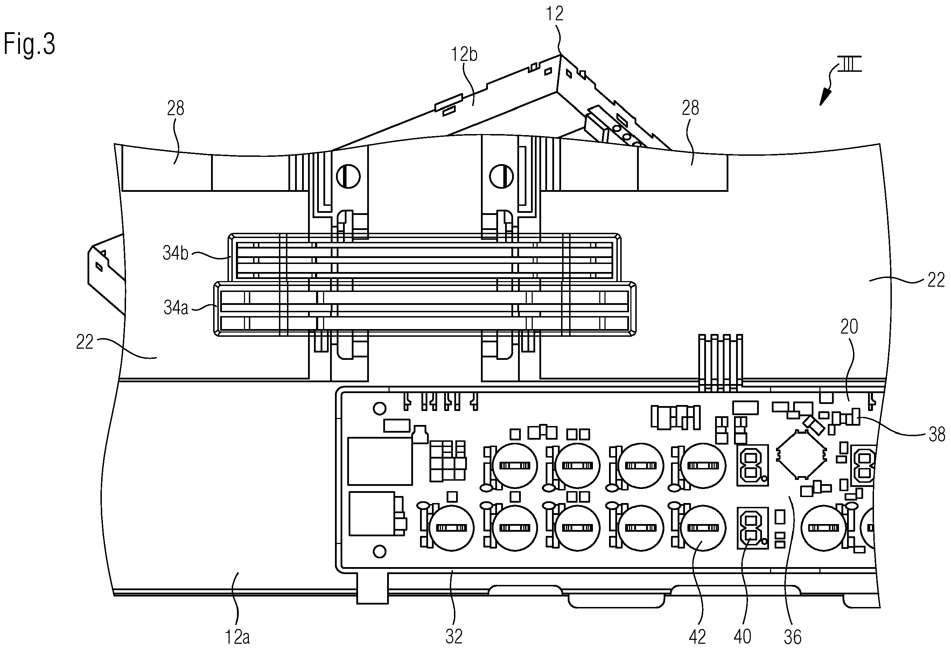

More details of a first embodiment of the user interface 20 are shown in Fig. 3, which illustrates a left half of the user interface, indicated by detail III, in a top view detached from the induction cooking hob 10 according to Fig. 2 and zoomed in for a larger view. Fig. 3 illustrates parts of corner regions of the two power boards 22, which corner sections also comprise terminals (not shown) for an interconnection of the power boards 22. Said terminals are connected by connection blocks 34a, 34b for power transmission and information transfer between the power boards 22 or from one power board 22 to the other. Said connection blocks 34a, 34b include wiring and substitute conventional cable harnesses. The illustrated section of the user interface 20 provides more details of its design. In particular, the upper surface of a user interface board 36 of the user interface 20 is indicated by a plurality of electric and electronic components 38 being elements of an electronic circuit included by the user interface board 36. The electric and electronic components 38 are interconnected with each other by conductor paths (not shown) according to a definite circuit diagram. Preferably, the electronic circuit is designed in SMD technology. The electronic circuit also comprises seven-segment displays 40 for status or setting displaying. In order to enable a user to make settings to the user interface 20, touch key elements 42, indicated by their circular touch key surfaces, are included in the electronic circuit for providing the option for switching operations. The structure of the user interface 20 according to Fig. 3 is based on conventional user interface designs with individual touch key elements 42, which are soldered to the circuit board of the user interface 20 for signal transfer.

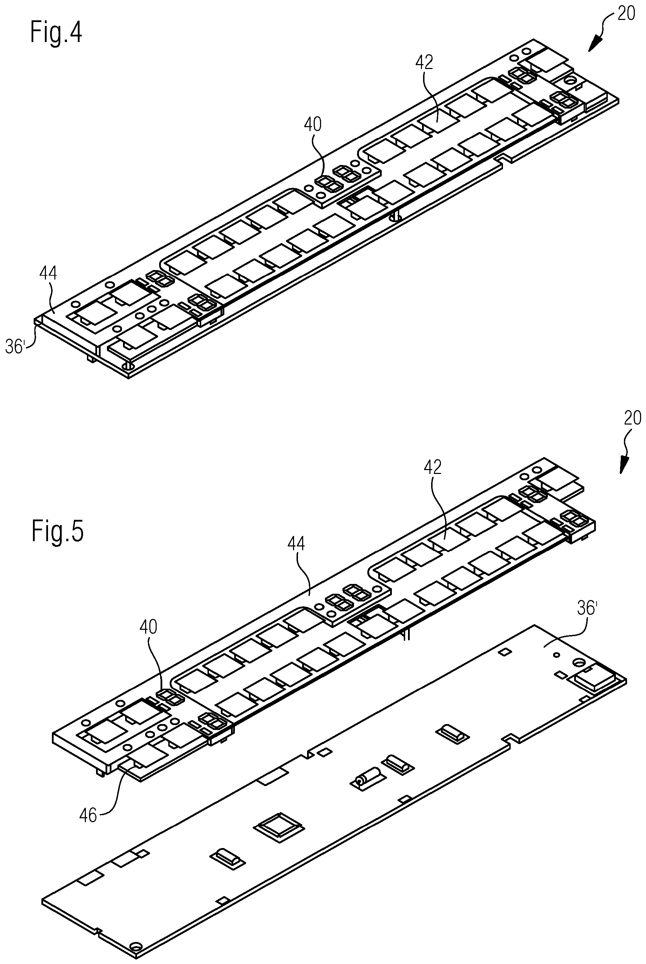

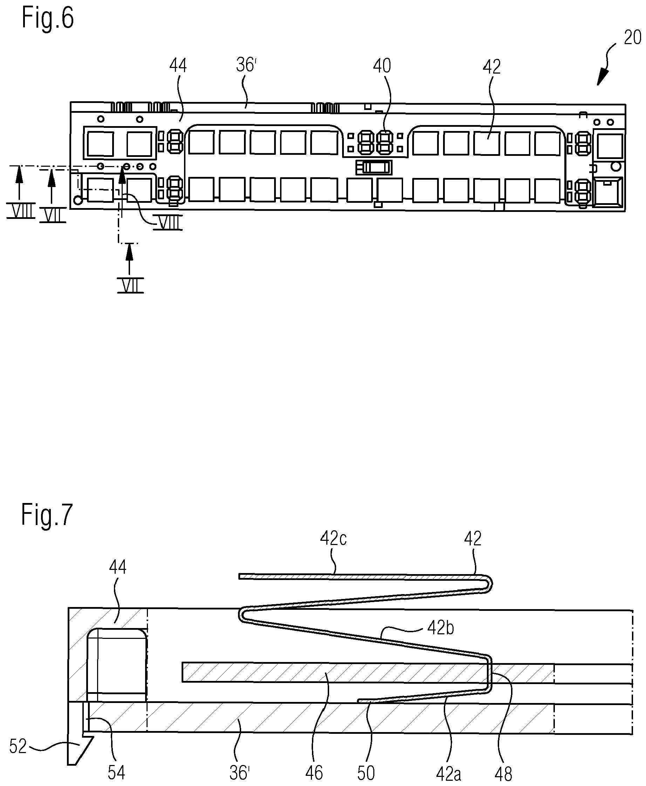

Figs. 4 and 5 show a second embodiment of the user interface 20 forming a representation of the concept according to the present invention. As illustrated with more clarity in the exploded view in Fig. 5, the user interface 20 of this second embodiment is an assembly of the user interface board 36' and a retainer element 44. The general structure of the user interface circuit of the second embodiment is similar to that one of the first embodiment. In particular the circuit configuration may be the same. However, in contrast to the first embodiment according to Fig. 3, both the seven-segment displays 40 and the touch key elements 42, which are of a square shape rather than to be circular as in Fig. 3, are liberated from a fixed connection to the user interface board 36', hence initially physically separated therefrom. Rather, these components 40, 42 are integrated in the retainer element 44. Only due to a coupling process between the retainer element 44 and the user interface board 36' an electrical connection of the seven-segment displays 40 and the touch key elements 42 with the user interface circuit takes place, as will be explained in more detail in the following with reference to Figs. 6 to 8, using the touch key elements 42 as an example.

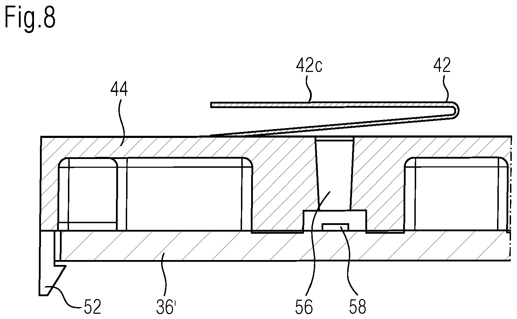

Fig. 6 shows the second embodiment of the user interface 20 in a top view. Further, this figure also indicates the localisation of two sectional views of segments of the user interface 20 according to sections VII - VII (illustrated in Fig. 7) and VIII - VIII (illustrated in Fig. 8).

The sectional view of segment VII - VII according to Fig. 7 shows the fixation of the touch key elements 42 by the retainer element 42, more specifically by a tongue shaped portion 46 of the retainer element 44. The retainer element 44 including its tongue shaped portion 46 are made of a plastic material, preferably produced by injection moulding, and the touch key elements 42, more specifically a vertically oriented short intermediate section 48 thereof, are embedded in the plastic material of the tongue shaped portion 46, which has been performed in an over-moulding process. Fig. 7 also shows the shaping of the touch key elements 42, which, in a side view, are designed in a Z-shape and functionally acting as a Z-shaped spring element, being elastically compressible in vertical direction. In general, a touch key element is divisible in a lower section 42a, a middle section 42b and an upper section 42c. The compressibility of the touch key element is implemented in its Z-shaped middle section 42b, which is foldable in an accordion manner, but in an elastic way. A major portion of the Z-shaped middle section 42b is arranged above the tongue shaped portion 46 of the retainer element 44 and only a predominant part of the lower section 42a is arranged below the tongue shaped portion 46. Moreover, the lower section 42a is designed like a leaf spring, an end section 50 thereof being bent off in a trough-shaped manner, which end section 50 forming a contact area for contacting a solder pad or a conductor path of the circuit on the user interface board 36'. Finally, the upper section 42c of the touch key element 42 forms the above-mentioned square-shaped touch key surface. As is not shown, in a finally assembled cooking hob said touch key surface is pressed against the lower surface of the glass panel 14 thereby forming the touch sensitive area on the upper side of the glass panel. In its finally assembled state the middle section 42b of the touch key element 42 is elastically compressed.

As can be also seen in Fig. 7, the mechanical connection of the retainer element 44 and the user interface board 36' is realized by means of a snap coupling. To this end, snap-in hooks 52 are integrally formed with the retainer element 44, which snap-in hooks 52 are configured to snap in allocated notches 54 at edges of the user interface board 36'. With snap-in hooks 52 snapped in the allocated edges 54, the end section 50 of the lower section 42a of the touch key element 42 is pressed against the solder pad or the conductor path on the user interface circuit, with the lower section 42a being set under preload.

As can be seen in the sectional view of segment VIII - VIII, illustrated in Fig. 8, the retainer element 44 also includes a light guide element 56, transmitting a light signal emitted by a light source 58, which is also part of the user interface circuit, to a respective display area on the user interface zone 21 for providing optical information to the user.

### List of reference numerals

- 10: cooking hob
- 12: casing
- 12a: bottom wall
- 12b: side walls
- 14: glass panel
- 15: cooking zones
- 16: heating coil units
- 18: coil carrier
- 20: user interface
- 21: user interface zone
- 22: power board
- 24, 26: electric / electronic elements
- 28: cooling channel
- 30: fan
- 32: user interface carrier
- 34a, 34b: connection blocks
- 36, 36': user interface boards
- 38: electric and electronic components
- 40: seven-segment displays
- 42: touch key elements
- 42a: lower section
- 42b: middle section
- 42c: upper section
- 44: retainer element
- 46: tongue shaped portion
- 48: intermediate section
- 50: end section
- 52: snap-in hook
- 54: notch
- 56: light guide element
- 58: light source

## Claims

1. A user interaction device for entering information and/or control commands to an input means (21), in particular to a user interface (20) of a household appliance (10), comprising at least one touch sensitive control element, which comprises an electrically conductive signal transmitting element (42), in particular a metallic spring, wherein a first end (50) or end portion of the electrically conductive signal transmitting element contacts a contact point on a circuit board (36') and a second end or end portion (42c) forms or contacts a touch sensitive area on or allocated to a touch surface of the input means (21), and wherein the at least one electrically conductive signal transmitting element (42) is supported and/or held in place by a retainer element (44), which retainer element (44) is arranged in a stationary position towards the circuit board (36'), in particular towards the contact point on the circuit board (36').

2. The user interaction device according to claim 1,
**characterized in that**
the contact point on the circuit board (36') is a solder pad or a section of a conductor path, and the first end (50) or end portion of the electrically conductive signal transmitting element (42) is pressed, in particularly by spring force, against the solder pad or the section of the conductor path.

3. The user interaction device according to claim 1 or 2,
**characterized in that**
the contact point on the circuit board (36') is a solder pad or a section of a conductor path, and the first end (50) or end portion of the electrically conductive signal transmitting element (42) is fixed to the solder pad or the section of the conductor path by means of soldering or welding.

4. The user interaction device according to anyone of the preceding claims,
**characterized in that**
the second end or end portion (42c) of the electrically conductive signal transmitting element (42) is a metal strip or a metal plate, particularly a rectangular or square-shaped metal plate, which abuts, preferably with its entire surface, on a bottom side or a reverse side of an operating panel (14) of the input means (21), wherein the metal strip or metal plate is pressed, in particularly by spring force, against said bottom or reverse side.

5. The user interaction device according to anyone of the preceding claims,
**characterized in that**
the retainer element (44) is arranged between and optionally spaced away from the circuit board (36') and the touch surface or an operating panel (14) of the input means (21).

6. The user interaction device according to anyone of the preceding claims,
**characterized in that**
the retainer element (44) comprises or is connected to a first means (52) of a clipping or snapping mechanism, which interacts with a second means (54) of the clipping or snapping mechanism, the second means (54) being arranged or arrangeable at the user interaction device, in particular at a housing of the user interaction device, or at the circuit board (36').

7. The user interaction device according to anyone of the preceding claims,
**characterized in that**
at least two electrically conductive signal transmitting elements (42) are supported and/or held in place by the retainer element (44), which electrically conductive signal transmitting elements (42) are arranged at or combined with the retainer element (44) such that they are connectable, preferably simultaneously connectable, to their related contact points on the circuit board (36') by a single assembly step.

8. The user interaction device according to claim 7,
**characterized in that**
the at least two electrically conductive signal transmitting elements (42) are at least two spiral springs or Z-shaped or S-shaped springs, particularly of identical shape and/or of identical spring force, wherein the retainer element (44) surrounds or embeds portions or sections, preferably middle portions or middle sections (48), of the at least two spiral springs or Z-shaped or S-shaped springs, which portions or sections (48) being particularly in the same spring sections of the two springs, more particularly said portions or sections being spaced from the first (59) and/or second (42c) ends or end sections of the related spring with the same distance.

9. The user interaction device according to claim 7 or 8,
**characterized in that**
the retainer element (44) is made of a plastic material and the at least two electrically conductive signal transmitting elements (42) are enclosed by the retainer element (44) during an injection moulding process.

10. The user interaction device according to anyone of the preceding claims,
**characterized in that**
the at least one electrically conductive signal transmitting element (42) and/or the retainer element (44) is/are included in or coupled with a light guide element (56) for a guided light signal transmission from a light source (58) on the circuit board (36') to the input means (21), particularly to a display field on the user interface (20), in particular on the operating panel (14), of the household appliance (10).

11. A household appliance (10), particularly a kitchen appliance, more particularly a cooking hob, specifically an induction cooking hob, comprising the user interaction device according to anyone of the claims 1 to 10.

12. A method for manufacturing a user interaction device for a household appliance (10), particularly for a cooking appliance, more particularly for a cooking hob, even more particularly for an induction cooking hob, the method comprising the steps
a. assembly of an electronic circuit on a circuit board (36') ;
b. integration of at least one electrically conductive signal transmitting element (42), particularly at least one metallic spring, for a touch sensitive control element in a retainer element (44); and
c. arrangement of the retainer element (44) on or above the circuit board (36'),
the method in particular being designed for being applied on a user interaction device according to anyone of the claims 1 or 10.

13. The method according to claim 12,
**characterized in that**
each of the steps a. to c. being performed in an automated assembly process and/or the step c. is performed at least approximately orthogonally to the circuit board (36').

14. The method according to claim 12 or 13,
**characterized in that**
during step c., the at least one electrically conductive signal transmitting element (42) is pressed against a contact point, particularly a solder pad, on the circuit board (36'), the contact pressure preferably being exerted by creating a spring preload.

15. The method according to anyone of the claims 12 to 14,
**characterized in that**
the retainer element (44) is arranged on the circuit board (36') by establishing a snap coupling or clip connection.
